# EUROPEAN PATENT APPLICATION

(11) **EP 2 088 469 A1**
(43) Date of publication of application: **12.08.2009**
(21) Application number: 07829714.0
(22) Date of filing: 12.10.2007
(51) Int. Cl.: G03F 7/32, H01L 21/027, H01L 21/304

(54) **SOLUTION FOR TREATMENT OF RESIST SUBSTRATE AFTER DEVELOPMENT PROCESSING, AND METHOD FOR TREATMENT OF RESIST SUBSTRATE USING THE SAME**

(30) Priority: 19.10.2006 JP 2006285262
(71) Applicant: AZ Electronic Materials USA Corp., Somerville, NJ 08876 (US)
(72) Inventor: NOYA, Go, Kakegawa-shi Shizuoka 4371412 (JP); SHIMAZAKI, Ryuta, Haibara-gun, Shizuoka 4210304 (JP); KOBAYASHI, Masakazu, Kakegawa-shi Shizuoka 4371412 (JP)
(74) Representative: Rippel, Hans Christoph
(86) International application number: PCT/JP2007/069978
(87) International publication number: WO 2008/047720

(57) **Abstract**

The present invention provides a resist substrate-treating solution for improving defects on a developed pattern surface, and also provides a resist substrate treatment method employing the treating solution. The resist substrate-treating solution comprises a solvent and a nitrogen-containing or oxygen-containing water-soluble polymer such as a polyamine, a polyol or a polyether. In the treatment method, a developed resist pattern is treated with the resist substrate-treating solution and then washed with pure water.

## Description

### TECHNICAL FIELD

The present invention relates to a resist substrate-treating solution. In detail, this invention relates to a resist substrate-treating solution advantageously used in a developing process of a photosensitive resin composition employed for manufacture of semiconductor devices, flat panel displays (FPDs) such as liquid crystal display elements, charge-coupled devices (CCDs), color filters, magnetic heads and the like; and the invention also relates to a developed resist substrate treatment method using the treating solution.

### BACKGROUD ART

In extensive fields including the manufacture of semiconductor integrated circuits such as LSIs, the preparation of FPD screens, and the production of circuit boards for color filters, thermal heads and the like, photolithography has hitherto been used for formation of fine elements or for microfabrication. In the photolithography, a positive- or negative-working photosensitive resin composition is used for resist pattern formation. As the positive-working photoresist, a photosensitive resin composition comprising an alkali-soluble resin and a photosensitive substance of quinonediazide compound, for example, is widely used.

Meanwhile, in recent years in manufacturing fine electronic devices, increased integration density and highly accelerated processing speed in LSIs have led to design rules requiring quarter-micron- or finer-scale fabrication rather than half-micron-scale fabrication, which the design rules formerly required. Since conventional light for exposure such as visible light or near UV light (wavelength: 400 to 300 nm) cannot fully cope with the design rules requiring finer fabrication, it is necessary to use radiation of shorter wavelength such as far UV light emitted from a KrF excimer laser (248 nm), an ArF excimer laser (193 nm) or the like, an X-ray or an electron beam. Accordingly, lithographic processes using the radiation of shorter wavelength have been proposed and gradually getting used in practice. To cope with the design rules requiring finer fabrication, the photoresist used in microfabrication must be a photosensitive resin composition capable of giving a pattern of high resolution. Further, it is also desired that the photosensitive resin composition be improved not only in resolution but also in sensitivity and in accuracy on shape and dimension of the pattern. In view of this, as a radiation-sensitive resin composition having sensitivity to the radiation of short wavelength and giving a pattern of high resolution, a "chemically amplified photosensitive resin composition" has been proposed. The chemically amplified photosensitive resin composition comprises a compound that generates an acid when exposed to radiation, and hence when the radiation is applied, the compound generates an acid and the acid serves as a catalyst in image-formation to improve sensitivity. Since the chemically amplified photosensitive resin composition is thus advantageous, it has been getting popularly used in place of conventional photosensitive resin compositions.

However, in accordance with increasing the fineness in fabrication as described above, problems such as foreign substances remaining on the substrate surface, pattern collapse and pattern roughness have been getting apparent. To cope with those problems, various methods have been studied. For example, it is studied to improve resist compositions. Further, it is also studied to develop a technology for improving the defects on the pattern surface (see, Patent documents 1 and 2).
[Patent document 1] Japanese Patent Laid-Open No. 2004-78217
[Patent document 2] Japanese Patent Laid-Open No. 2004-184648

### DISCLOSURE OF INVENTION

### PROBLEM TO BE SOLVED BY THE INVENTION

It is an object of the present invention to provide a resist substrate-treating solution for improving defects (foreign substances redeposited) on the surface of the developed pattern. Further, it is another object of the present invention to provide a resist substrate treatment method using that treating solution.

### MEANS FOR SOLVING PROBLEM

The present invention resides in a developed resist substrate-treating solution, comprising a solvent and a nitrogen-containing water-soluble polymer or an oxygen-containing water-soluble polymer.

The present invention also resides in a resist substrate treatment method, wherein a developed resist pattern is treated with a resist substrate-treating solution comprising a solvent and a nitrogen-containing water-soluble polymer or an oxygen-containing water-soluble polymer, and is then washed with pure water.

### EFFECT OF THE INVENTION

The present invention makes it possible, without seriously increasing the production cost or impairing the production efficiency, to form a developed pattern having few defects caused by resist fragments redeposited on the remaining resist surface or on the substance surface where the resist is removed by development. In a production process according to the present invention, it is unnecessary to introduce a new apparatus and it is possible to employ relatively inexpensive materials, and hence a pattern having excellent surface condition can be produced without increasing the production cost.

### BEST MODE FOR CARRYING OUT THE INVENTION

The pattern formation method according to the present invention is described below in detail.
In the pattern formation method of the invention, a resist pattern after development is treated with a resist substrate-treating solution. There is no particular restriction on the process by which a resist pattern is developed to obtain the pattern to be treated, and hence any process can be used. Accordingly, the lithographic process for preparing the pattern to be treated can be carried out in any known manner of forming a resist pattern from a conventional positive- or negative-working photosensitive resin composition. Below described is a typical process for forming a pattern to be treated with the resist substrate-treating solution of the present invention.

First, a photosensitive resin composition is coated on a surface, which can be pretreated, if necessary, of a substrate, such as a silicon substrate or a glass substrate, according to a known coating method such as spin-coating method, to form a photosensitive resin composition layer. Prior to the coating of the photosensitive resin composition, an antireflection film can be beforehand formed by coating under or above the resist. The antireflection film can improve the section shape and the exposure margin.

Any known photosensitive resin composition can be used in the pattern formation method of the present invention. Representative examples of the compositions usable in the present invention include: a composition comprising a quinonediazide type photosensitive substance and an alkali-soluble resin, a chemically amplified photosensitive resin composition (which are positive-working compositions); a composition comprising a photosensitive functional group-containing polymer such as polyvinyl cinnamate, a composition comprising an azide compound such as an aromatic azide compound or a bisazide compound with a cyclized rubber, a composition comprising a diazo resin, a photo-polymerizable composition comprising an addition-polymerizable unsaturated compound, and a chemically amplified negative-working photosensitive resin composition (which are negative-working compositions).

Examples of the quinonediazide type photosensitive substance used in the positive-working composition comprising a quinonediazide type photosensitive substance and an alkali-soluble resin include: 1,2-benzoquinonediazide-4-sufonic acid, 1,2-naphthoquinonediazide-4-sufonic acid, 1,2-naphthoquinonediazide-5-sufonic acid, and sufonic esters or amides thereof. Examples of the alkali-soluble resin include: novolak resin, polyvinyl phenol, polyvinyl alcohol, and copolymers of acrylic acid or methacrylic acid. The novolak resin is preferably prepared from one or more phenols such as phenol, o-cresol, m-cresol, p-cresol and xylenol in combination with one or more aldehydes such as formaldehyde and paraformaldehyde.

Either positive- or negative-working chemically amplified photosensitive resin composition can be used in the pattern formation method of the present invention. The chemically amplified resist generates an acid when exposed to radiation, and the acid serves as a catalyst to promote chemical reaction by which solubility to a developer is changed within the areas irradiated with the radiation to form a pattern. For example, the chemically amplified photosensitive resin composition comprises an acid-generating compound, which generates an acid when exposed to radiation, and an acid-sensitive functional group-containing resin, which decomposes in the presence of acid to form an alkali-soluble group such as phenolic hydroxyl or carboxyl group. The composition may comprise an alkali-soluble resin, a crosslinking agent and an acid-generating compound.

The photosensitive resin composition layer formed on the substrate is prebaked, for example, on a hot plate to remove solvent contained in the composition, to form a photoresist film. The prebaking temperature depends upon the solvent and the photosensitive resin composition, but is normally 20 to 200°C, preferably 50 to 150°C.

The photoresist film is then subjected to exposure through a mask, if necessary, by means of known exposure apparatus such as a high-pressure mercury lamp, a metal halide lamp, an ultra-high pressure mercury lamp, a KrF excimer laser, an ArF excimer laser, a soft X-ray irradiation system, and an electron beam lithography system.

After the exposure, baking treatment may be carried out, if necessary, and then development such as paddle development is carried out to form a resist pattern. The resist is normally developed with an alkali developer. Examples of the alkali developer include an aqueous solution of sodium hydroxide or tetramethylammonium hydroxide (TMAH). After the development, the resist pattern is rinsed (washed) with a rinse solution, preferably, pure water. The thus-formed resist pattern is employed as a resist for etching, plating, ion diffusion or dyeing, and then, if necessary, peeled away.

The resist substrate treatment method according to the present invention can be applied to a resist pattern of any pattern size. However, the method according to the present invention is remarkably effective in improvement when the method is applied to produce a fine resist pattern required to have delicate surface character and precise dimension. Accordingly, the method of the present invention is preferably combined with a lithographic process capable of giving a fine resist pattern, such as, a lithographic process comprising exposure at a wavelength of 250 nm or shorter with a light source of a KrF excimer laser, an ArF excimer laser, an X-ray irradiation system or an electron beam lithography system. Further, the lithographic process preferably produces a resist pattern having a pattern dimension in which a line width of the line-and-space pattern is not more than 300 nm, preferably not more than 200 nm or in which a hole diameter of the contact hole pattern is not more than 300 nm, preferably not more than 200 nm.

The thickness of the resist pattern is properly determined according to the aimed use, but is in the range of generally 0.1 to 5 µm, preferably 0.1 to 2.5 µm, more preferably 0.2 to 1.5 µm.

In the resist substrate treatment method of the present invention, a resist pattern after subjected to development is treated with a resist substrate-treating solution containing water and a nitrogen-containing water-soluble polymer or an oxygen-containing water-soluble polymer. As the nitrogen-containing or oxygen-containing water-soluble polymer, any polymer can be used as long as it contains a nitrogen atom or an oxygen atom and is soluble in water.

The nitrogen-containing water-soluble polymer contains a nitrogen atom in the form of, for example, an amino group, a pyrazole group or an amide group. Preferred is a water-soluble polymer containing an amino group. There is no particular restriction on the number of the nitrogen atoms contained in the polymer. However, in order to enhance the effect on reducing the pattern size, the number of nitrogen atoms is preferably 5 to 5000, more preferably 5 to 2000 per molecule of the polymer.

The nitrogen-containing water-soluble polymer is preferably a polyamine represented by the following formula (I): 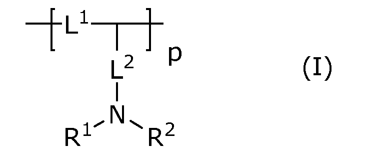 in which L¹ and L² are divalent linking groups such as single bonds or divalent functional groups. There is no particular restriction on the number of carbon atoms contained in L¹ and L², but each contains preferably 0 to 20 carbon atoms, more preferably 0 to 5 carbon atoms. The groups L¹ and L² are not particularly restricted, but they are generally hydrocarbon groups, preferably alkylene groups or arylene groups, more preferably alkylene groups. In the formula, R¹ and R² may be any functional groups. There is no particular restriction on the number of carbon atoms contained in R¹ and R², but they are generally hydrogen atoms or hydrocarbon groups and hence each contains preferably 0 to 20 carbon atoms, more preferably 0 to 5 carbon atoms. The groups R¹ and R² are not particularly restricted, but they are generally hydrocarbon groups, preferably alkyl groups or aryl groups, more preferably alkyl groups. The groups R¹ and R² may be combined to form a ring, or otherwise R¹ or R² may be combined with carbon atoms in L¹ or L², respectively, to form a ring. In the above formula, p is a number indicating polymerization degree. If necessary, each of the groups L¹, L², R¹ and R² may have a substituent group such as hydroxyl, a carboxyl group, an amino group, a carbonyl group or an ether group. In one molecule of the polymer, two or more different groups may serve as each of L¹, L², R¹ and R². Further, in the case where the groups L¹, L², R¹ and R² contain carbon atoms, the number of the carbon atoms is selected within such a range that the polymer can be dissolved in water at a predetermined concentration. For example, L¹ and L² are preferably an alkylene group and methylene, respectively. Examples of the polyamine include polyallylamine, poly-N-methylallylamine, poly-N,N'-dimethylallylamine, and poly(N-methyl-3,5-piperidinediylmethylene). The polymerization degrees of those polymers are not particularly restricted, and can be desirably determined according to various conditions such as the monomer structure, concentration of the resist substrate-treating solution and the resist compound. However, the number of p in polyallylamine is generally 5 to 500, preferably 10 to 400. The number of p in poly-N,N'-dimethyl-allylamine is generally 5 to 50, preferably 5 to 30, and that in poly(N-methyl-3,5-piperidinediylmethylene) is generally 5 to 50, preferably 10 to 30. Concrete examples of structures and polymerization degrees of the preferred polymers are shown below. The shown polymers are commercially available from, for example, Nitto Boseki Co., Ltd.

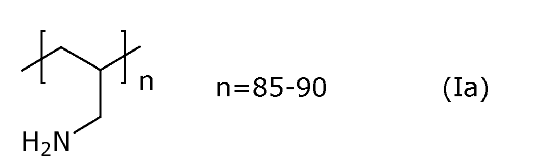

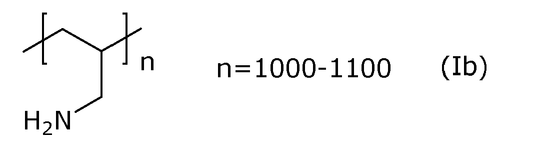

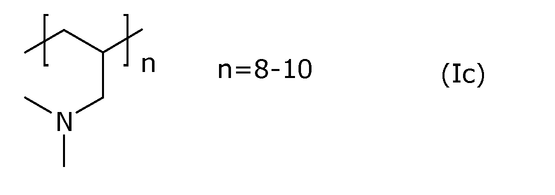

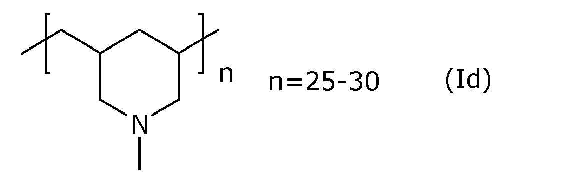

If both R¹ and R² in the formula (I) are hydrogen atoms, namely, if the nitrogen atom in the formula (I) forms a primary amino group, the effect of the present invention is enhanced. Accordingly, the polymer having that structure, for example, the polymer of the above (Ia) or (Ib) is particularly preferred.

The oxygen-containing water-soluble polymer contains an oxygen atom in the form of, for example, hydroxyl, an ether group, a carboxyl group, a carbonyl group or an amide group. Preferred is a water-soluble polymer containing hydroxyl or an ether group. There is no particular restriction on the number of the oxygen atoms contained in the polymer. However, in order to enhance the effect on reducing the pattern size, the number of oxygen atoms is preferably 5 to 3000, more preferably 5 to 1000 per molecule of the polymer.

The oxygen-containing water-soluble polymer is preferably a polyol represented by the following formula (II) or a polyether represented by the following formula (III):

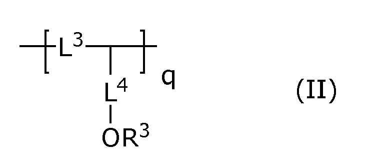

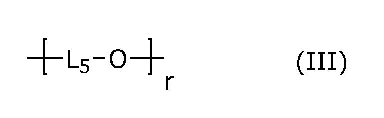

In the above formulas, L³ to L⁵ are divalent linking groups such as single bonds or divalent functional groups. There is no particular restriction on the number of carbon atoms contained in the linking groups, but each contains preferably 0 to 20 carbon atoms, more preferably 0 to 5 carbon atoms. The linking groups are not particularly restricted, but they are generally single bonds or hydrocarbon groups. Among the hydrocarbon groups, alkylene groups or arylene groups are preferred and alkylene groups are more preferred. In the formula (II), R³ may be any functional group but is preferably hydrogen, an alkyl group or a protecting group such as acetyl, benzyl or an acetal group. There is no particular restriction on the number of carbon atoms contained in R³, which is generally hydrogen or an alkyl group. The number of carbon atoms contained in R³ is preferably 0 to 20, more preferably 0 to 5. In the above formulas, q and r are numbers indicating polymerization degrees. If necessary, each of the groups L³ to L⁵ and R³ may have a substituent group such as hydroxyl, a carboxyl group, an amino group, a carbonyl group or an ether group. In one molecule of the polymer, two or more different groups may serve as each of L³ to L⁵ and R³. Further, in the case where the groups L³ to L⁵ and R³ contain carbon atoms, the number of the carbon atoms is selected within such a range that the polymer can be dissolved in water at a predetermined concentration. The oxygen-containing water-soluble polymer is, for example, a compound represented by the following formula. 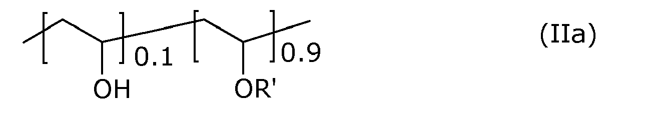 in which R' is a carboxyl group and the molecular weight is approx. 24000. The polymer of the formula (IIa) is commercially available (e.g., PV-205 [trade mark], manufactured by Kuraray Co., Ltd.). Further, polyols, polyacrylic acid and polymethacrylic acid are also usable as the oxygen-containing water-soluble polymers. These water-soluble polymers are commercially available (e.g., JURYMER AC-10SL [trade mark], manufactured by Nihon Junyaku Co., Ltd.; and POVAL [trade mark], manufactured by Kuraray Co., Ltd.).

According to the requirement, it is possible to use the nitrogen-containing or oxygen-containing water-soluble polymer having a desired molecular weight. The molecular weight of the polymer is in the rage of generally 500 to 200000, preferably 1000 to 100000. However, since the proper molecular weight depends upon the main chain structure and the functional groups, it is often possible to use the polymer having a molecular weight out of the above range.

Two or more polymers can be used in combination, if necessary.

The resist substrate-treating solution according to the present invention comprises a solvent as well as the aforementioned nitrogen-containing or oxygen-containing water-soluble polymer. There is no particular restriction on the solvent, and any solvent can be used. However, in consideration of affinity with the developer and the rinse solution, water is preferably used. However, for improving wettability, a small amount of organic solvent can be added as a cosolvent. Examples of the cosolvent include alcohols such as methanol and ethanol, ketones such as acetone and methyl ethyl ketone, and esters such as ethyl acetate. If necessary, other auxiliary components can be incorporated. For example, acidic or basic substances and surfactants can be added unless they impair the effect of the present invention.

There is no particular restriction on the concentration of the nitrogen-containing or oxygen-containing water-soluble polymer dissolved in the treating solution, but it is preferred to control the concentration according to what the pattern is used for and how the pattern is used. Generally, the treating solution containing the polymer in a high concentration is apt to shorten the time to complete the treatment, and gives large effect on improving the foreign substances redeposited on the pattern surface. On the other hand, if the treating solution contains the polymer in a low concentration, it takes a short time to complete rinsing with pure water after the treatment. Further, what kind of the polymer is most preferred and how much amount is most preferred are dependent upon the photosensitive resin composition and other conditions. Accordingly, the concentration is preferably so determined that the required characteristics can be obtained in good balance. The optimum concentration of the nitrogen-containing or oxygen-containing water-soluble polymer is thus not fixed, but is generally in the range of 0.01 to 10%, preferably 0.1 to 5%, more preferably 0.1 to 2% based on the total weight of the developed resist substrate-treating solution.

The treatment of resist pattern by use of the resist substrate-treating solution can be performed, for example, by immersing the resist substrate in the treating solution or by subjecting the resist substrate to dip-coating or paddle-coating with the treating solution. The time for which the resist substrate is treated with the treating solution, namely, the treatment time is not particularly limited. However, to enhance the effect on improving the foreign substances redeposited on the pattern surface, the treatment time is preferably not less than 1 second, more preferably not less than 10 seconds. The upper limit of the treatment time is not particularly limited, but the treatment time is preferably not more than 300 seconds in view of the production efficiency.

There is also no particular restriction on the temperature of the treating solution. However, in view of the effect on improving the foreign substances redeposited on the pattern surface, the temperature is generally in the range of 5 to 50°C, preferably 20 to 30°C.

Generally in the resist substrate after subjected to development, fragments of the resist removed by the development are often redeposited as foreign substances on the surface where the resist still remains or on the bared substrate surface where the resist is removed by the development. According to the resist substrate treatment method of the present invention, the redeposited resist fragments can be removed to obtain the surface having few defects. The mechanism of this effect is yet to be revealed clearly. However, it is presumed that the nitrogen atoms or the oxygen atoms in the water-soluble polymer contained in the resist-treating solution adsorb the redeposited resist fragments by use of their unpaired electrons or by hydrogen bonding, so as to remove the resist fragments redeposited on the remaining resist surface or on the bared substrate surface.

In the resist substrate treatment method according to the present invention, the resist substrate is rinsed with pure water, namely, is subjected to rinse step, after treated with the aforementioned treating solution. This rinse step is carried out for the purpose of washing out the resist substrate-treating solution. Particularly in the case where the treating solution has a high concentration, the rinsing with pure water is inevitably carried out after the treatment with the treating solution so that the resist pattern may not undergo troubles in the subsequent steps, for example, so that the treating solution remaining on the resist surface may not cause problems in the etching step.

Further, in the resist substrate treatment method according to the present invention, it is preferred that the resist substrate after subjected to development be also rinsed with pure water before treated with the treating solution containing the polymer of the present invention. The rinse step before the treatment with the treating solution is carried out for the purpose of washing out a developer remaining on the resist pattern. In order to prevent the developer from contaminating the treating solution and to treat the resist substrate with a minimum amount of the treating solution, the resist substrate after development is preferably rinsed with pure water before treated with the treating solution.

The rinsing with pure water can be carried out in a desired manner. For example, the resist substrate is immersed in the rinse solution, or otherwise the rinse solution is dropped or sprayed onto the substrate surface while the substrate is being rotating.

In the present invention, the resist pattern after development is treated with the aforementioned resist substrate-treating solution. After the development or after the rinsing with pure water, the resist pattern is normally not dried and immediately treated with the treating solution. However, if necessary, before treated with the treating solution, the resist pattern can be dried immediately after the development or after the rinsing procedure subsequent to the development. Even so, the effect of the invention can be obtained.

The resist pattern whose surface condition is thus improved by the resist substrate treatment method of the present invention is then further processed according to the aimed use. The resist substrate treatment method of the present invention by no means restricts the subsequent steps, and hence the resist pattern can be processed in known manners.

The pattern formed by the method of the present invention can be employed for manufacture of flat panel displays (FPDs) such as liquid crystal displays, charge-coupled devices (CCDs), color filters, magnetic heads and the like, in the same manner as the pattern formed by the conventional method is employed for.

The present invention is further explained by use of the following Examples, but they by no means restrict the embodiments of the present invention.

### Comparative Example 1

An anti-reflection film-forming composition (AZ KrF-17B [trade mark], manufactured by AZ Electronic Materials (Japan) K.K.) was spin-coated on an 8-inch silicon wafer by means of a spin coater (manufactured by Tokyo Electron Limited), and then baked on a hot-pate at 180°C for 60 seconds to obtain a 800 Å-thick film. The thickness was measured by a thickness monitor (manufactured by Prometrix). On the thus-obtained anti-reflection film, a 248 nm-exposure type chemically amplified photoresist containing a polymer of polystyrene skeleton (AZ DX 6850P [trade mark], manufactured by AZ Electronic Materials (Japan) K.K.) was spin-coated and then baked on a hot-pate at 100°C for 90 seconds to obtain a 0.68 µm-thick resist film. The obtained resist film was then subjected to exposure by means of a reduced projection exposure apparatus (FPA-3000EX5 [trade mark], manufactured by Canon Inc.) with Quadropole at 248 nm. Thereafter, the resist substrate was baked on a hot-pate at 110°C for 60 seconds, and then paddle development was carried out with 2.38 wt.% aqueous solution of tetramethylammonium hydroxide (developer AZ 300MIF [trade mark], manufactured by AZ Electronic Materials (Japan) K.K.) at 23°C for 1 minute. Successively, after rinsed with pure water, the resist substrate was spin-dried to obtain a short line pattern of 250 nm.

### Comparative Example 2

After developed in the same manner as in Comparative Example 1,
(a) the resist substrate was not rinsed with pure water and immediately treated with the resist substrate-treating solution for 20 seconds, or
(b) the resist substrate was not rinsed with pure water and immediately treated with the resist substrate-treating solution for 20 seconds, and then rinsed with pure water for 15 seconds, or otherwise
(c) the resist substrate was rinsed with pure water and treated with the resist substrate-treating solution for 15 seconds, and then rinsed again with pure water for 15 seconds.
The resist substrate-treating solution used in each treatment contained triethanolamine in various concentrations shown in Table 1.

### Examples

The procedure of Comparative Example 2 was repeated except for using resist substrate-treating solutions containing the polymers shown in Table 1 in various concentrations shown in Table 1.

The resist patterns obtained above were observed by means of a surface defects inspector (KLA-2115 [trade mark], manufactured by KLA-Tencor Co.), to evaluate the foreign substances redeposited on the pattern surface. The results were as set forth in Table 1.

Table 1

**Table 1 Evaluation of redeposited foreign substances according to concentration of resist-treating solution**

| Polymer | Procedures | Concentration of resist-treating solution | | | | | |
|---|---|---|---|---|---|---|---|
| | | 0% | 0.01% | 0.1% | 1% | 2% | 5% |
| Triethanolamine | develop - treat | >10000 | >10000 | >10000 | >10000 | >10000 | >10000 |
| | develop - treat - rinse | | >10000 | >10000 | >10000 | >10000 | >10000 |
| | develop - rinse - treat - rinse | | >10000 | >10000 | >10000 | >10000 | >10000 |
| (Ia) | develop - treat | >10000 | >10000 | >10000 | >10000 | >10000 | >10000 |
| | develop - treat - rinse | | 0 | 0 | 0 | 0 | 0 |
| | develop - rinse - treat - rinse | | 0 | 0 | 0 | 0 | 0 |
| (Ib) | develop - treat | >10000 | >10000 | >10000 | >10000 | >10000 | >10000 |
| | develop - treat - rinse | | 0 | 0 | 0 | 0 | 0 |
| | develop - rinse - treat - rinse | | 0 | 0 | 0 | 0 | 0 |
| (Ic) | develop - treat | >10000 | >10000 | >10000 | >10000 | >10000 | >10000 |
| | develop - treat - rinse | | 952 | 883 | 56 | 48 | 38 |
| | develop - rinse - threat - rinse | | 513 | 435 | 23 | 56 | 20 |
| (Id) | develop - treat | >10000 | >10000 | >10000 | >10000 | >10000 | >10000 |
| | develop - treat - rinse | | 943 | 760 | 189 | 85 | 65 |
| | develop - rinse - treat - rinse | | 825 | 654 | 46 | 37 | 26 |
| (IIa) | develop - treat | >10000 | >10000 | >10000 | >10000 | >10000 | >10000 |
| | develop - treat - rinse | | 9035 | 634 | 13 | 8 | 6 |
| | develop - rinse - threat - rinsed | | 5053 | 334 | 5 | 3 | 4 |

| | | | | | | | |
|---|---|---|---|---|---|---|---|
| Remark) melt.: the resist surface was melted. | | | | | | | |

## Claims

1. A developed resist substrate-treating solution, comprising a solvent and a nitrogen-containing water-soluble polymer or an oxygen-containing water-soluble polymer.

2. The developed resist substrate-treating solution according to claim 1, wherein said nitrogen-containing water-soluble polymer is an amino group-containing water-soluble polymer.

3. The developed resist substrate-treating solution according to claim 2, wherein the amino group contained in said amino group-containing water-soluble polymer is a primary amino group.

4. The developed resist substrate-treating solution according to claim 1, wherein said oxygen-containing water-soluble polymer is a polyol or a polyether.

5. The developed resist substrate-treating solution according to any of claims 1 to 4, wherein said nitrogen-containing water-soluble polymer or said oxygen-containing water-soluble polymer is contained in a concentration of 0.01 to 10% based on the total weight of the developed resist substrate-treating solution.

6. A resist substrate treatment method, wherein a developed resist pattern is treated with a resist substrate-treating solution comprising a solvent and a nitrogen-containing water-soluble polymer or an oxygen-containing water-soluble polymer, and is then washed with pure water.

7. The resist substrate treatment method according to claim 6, wherein the time for which said resist pattern is treated with said resist substrate-treating solution is in the range of 1 to 300 seconds.

8. The resist substrate treatment method according to claim 6 or 7, wherein washing with pure water is also carried out immediately before the treatment with said resist substrate-treating solution.
